# EUROPEAN PATENT APPLICATION

(11) **EP 4 621 760 A1**
(43) Date of publication of application: **24.09.2025**
(21) Application number: 23907353.9
(22) Date of filing: 20.10.2023
(51) Int. Cl.: G09F 9/302, H05K 5/00

(54) **SEPARATION DEVICE AND DISPLAY DEVICE COMPRISING SAME**

(30) Priority: 23.12.2022 KR 20220183594
(71) Applicant: Samsung Electronics Co., Ltd., Suwon-si, Gyeonggi-do 16677 (KR)
(72) Inventor: KIM, Kiwoong, Suwon-si Gyeonggi-do 16677 (KR); KIM, Dowan, Suwon-si Gyeonggi-do 16677 (KR); KIM, Yoonah, Suwon-si Gyeonggi-do 16677 (KR); PARK, Chiun, Suwon-si Gyeonggi-do 16677 (KR); JEON, Jinhyeong, Suwon-si Gyeonggi-do 16677 (KR); HWANG, Kwangsung, Suwon-si Gyeonggi-do 16677 (KR)
(74) Representative: Appleyard Lees IP LLP
(86) International application number: PCT/KR2023/016392
(87) International publication number: WO 2024/136067

(57) **Abstract**

A display device according to an embodiment a display module comprising a substrate on which light-emitting diodes (LEDs) facing forward are mounted and in which a fastening hole is formed for insertion of a fastening member, a cabinet disposed on a rear side of the display module and comprising a magnet such that the display module and the cabinet are coupled via magnetic attraction, and a separation device detachably mountable to the display module, wherein the separation device includes a grip portion extending in one direction, an extension portion extending from the grip portion, and an insertion member extending from the extension portion and having a cross-sectional area corresponding to the fastening hole so as to be insertable into the display module.

## Description

### [TECHNICAL FIELD]

The disclosure relates to a separation device and a display device comprising the same, and more particularly, to a separation device capable of easily separating a display module and a display device comprising the same.

### [BACKGROUND ART]

A display device is a type of output device that converts acquired or stored electrical information into visual information and displays such information to a user.

To realize a large-sized screen, the display device may include a plurality of display modules and a cabinet supporting the plurality of display modules by continuously tiling them in the up, down, left, and right directions. The cabinets supporting the plurality of display modules may be provided as a plurality, and the plurality of cabinets may be arranged to be continuously tiled in the up, down, left, and right directions as are the plurality of display modules. The plurality of display modules supported by the plurality of cabinets may form a single large-sized screen. In this case, the cabinets and the display modules may be coupled by magnetic force.

In the event of damage or failure of any of the plurality of display modules, each module may need to be replaced. To separate each display module from the cabinet, a force greater than the attractive force between the cabinet and the display module is required to separate the display module from the cabinet.

### [DISCLOSURE]

### [TECHNICAL PROBLEM]

An embodiment of the present disclosure provides a separation device capable of easily separating a display module from a cabinet and a display device including the same.

An embodiment of the present disclosure provides a separation device capable of safely separating a display module from a cabinet and a display device including the same.

Technical tasks to be achieved in this document are not limited to the technical tasks mentioned above, and other technical tasks not mentioned will be clearly understood by those skilled in the art from the description below.

### [TECHNICAL SOLUTION]

According to an embodiment of the disclosure, a display device includes a display module comprising a substrate on which light-emitting diodes (LEDs) facing forward are mounted and in which a fastening hole is formed for insertion of a fastening member, a cabinet disposed on a rear side of the display module and comprising a magnet such that the display module and the cabinet are coupled via magnetic attraction, and a separation device detachably mountable to the display module, wherein the separation device includes a grip portion extending in one direction, an extension portion extending from the grip portion, and an insertion member extending from the extension portion and having a cross-sectional area corresponding to the fastening hole so as to be insertable into the display module.

According to an embodiment of the disclosure, a separation device is capable of detaching a display module from a cabinet, the separation device including a handle portion, and an extension portion extending from the handle portion, an insertion member secured to the extension portion, the insertion member having a head and an insertion portion extending from the head and having a cross-sectional area smaller than the head for insertion into the display module, a first plate through which the insertion portion of the insertion member is passed and configured to contact a surface of the head to prevent linear movement of the insertion member, and a second plate into which the head of the insertion member is inserted and corresponding to the head of the insertion member to prevent rotation of the insertion member.

According to an embodiment of the disclosure, a display device includes a display module comprising a substrate on which an LED is mounted, a holder disposed on a rear side of the substrate and having a fastening hole formed therein for coupling with the substrate, and a reinforcing member disposed on a rear side of the holder; a cabinet coupled to a rear side of the display module, the cabinet comprising a magnet having a magnetic attraction with the reinforcing member; and a separation device detachably mountable to the display module, wherein the separation device includes a grip member including a grip portion and an extension portion extending from the grip portion toward the display module, a case coupled to the grip member, and an insertion member accommodated in the case and having a cross-sectional area corresponding to the fastening hole for insertion into the display module, wherein, to detach the display module from the cabinet, the insertion member is inserted into the fastening hole, the separation device is rotated to cause the insertion member to be held to the fastening hole, and the separation device is pulled forward, thereby separating the display module from the cabinet.

### [DESCRIPTION OF DRAWINGS]

FIG. 1 is a perspective view of a display device, according to an embodiment.
FIG. 2 is an exploded perspective view of a display in the display device according to an embodiment.
FIG. 3 is a partially enlarged view of the display device of FIG. 2.
FIG. 4 is a rear exploded perspective view of the display in the display device of FIG. 2, according to an embodiment.
FIG. 5 is an enlarged view of the display of FIG. 4.
FIGS. 6 and 7 are exploded views of a display module in the display device according to an embodiment.
FIG. 8 is a front view of a cabinet in the display device according to an embodiment.
FIG. 9 is a perspective view of a separation device in the display device according to an embodiment.
FIGS. 10 and 11 are exploded perspective views of the separation device shown in FIG. 9.
FIGS. 12 to 14 are views illustrating a process by which the separation device is mounted to the display module in the display device according to an embodiment.
FIG. 15 is a cross-sectional view of the display device shown in FIG. 14.
FIG. 16 is an enlarged view of the display device shown in FIG. 15.
FIG. 17 is a view of the display module being detached from the cabinet in the display device according to an embodiment.

### [MODES OF THE INVENTION]

Embodiments described in the disclosure and configurations shown in the drawings are merely examples of the embodiments of the disclosure and may be modified in various different ways at the time of filing of the present application to replace the embodiments and drawings of the disclosure.

In addition, the same reference numerals or signs shown in the drawings of the disclosure indicate elements or components performing substantially the same function. The singular form of a noun corresponding to an item may include one or a plurality of the items unless clearly indicated otherwise in a related context.

Also, the terms used herein are used to describe the embodiments and are not intended to limit and/or restrict the disclosure. The singular forms "a," "an" and "the" are intended to include the plural forms as well, unless the context clearly indicates otherwise. In this disclosure, the terms "including", "having", and the like are used to specify features, figures, steps, operations, elements, components, or combinations thereof, but do not preclude the presence or addition of one or more of the features, figures, steps, operations, elements, components, or combinations thereof.

It will be understood that, although the terms first, second, primary, secondary, etc., may be used herein to describe various elements, but elements are not limited by these terms. These terms are only used to distinguish one element from another element. For example, without departing from the scope of the disclosure, a first element may be termed as a second element, and a second element may be termed as a first element. The term of "and/or" includes a plurality of combinations of relevant items or any one item among a plurality of relevant items.

Further, as used in the disclosure, the terms "front", "rear", "top", "bottom", "side", "left", "right", "upper", "lower", and the like are defined with reference to the drawings, and are not intended to limit the shape and position of each component.

Various embodiments of the present disclosure will be described in detail below with reference to the accompanying drawings.

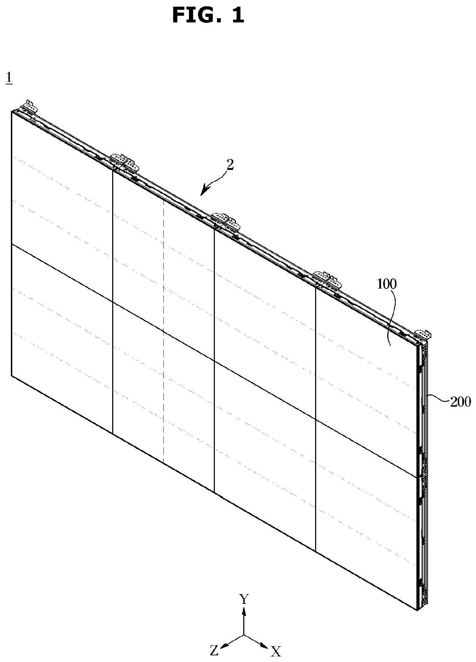

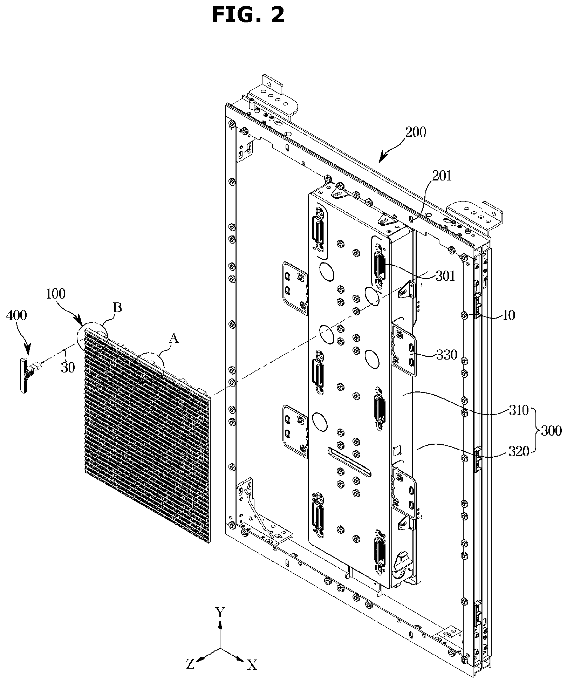

FIG. 1 is a perspective view of a display device according to an embodiment. FIG. 2 is an exploded perspective view of a display in the display device according to an embodiment. FIG. 2 illustrates a cabinet and a display module separated from the cabinet in the display device according to an embodiment, viewed from the front.

FIG. 1 shows an X-axis, a Y-axis, and a Z-axis direction perpendicular to each other, wherein the X-axis direction may refer to a left-to-right direction, the Y-axis direction may refer to an up-and-down direction, and the Z-axis direction may refer to a front-to-back direction. However, the meanings of the X-axis, Y-axis, and Z-axis directions are not limited to the example described above and may be varied.

Referring to FIGS. 1 and 2, a display device 1 may be a device that displays information, materials, data, and the like, in the form of characters, shapes, graphs, images, and the like, and examples, such as billboards, electronic signboards, screens, televisions, monitors, and the like may be implemented as the display device 1. The display device 1 may be mounted on a wall or ceiling, or may be mounted on an indoor or outdoor ground by means of a stand (not shown).

The display device 1 may include a display 2. For example, the display device 1 may include a plurality of displays 2. In FIG. 1, the display device 1 includes eight displays 2, but the number of displays 2 is not limited thereto.

The display 2 may include a display module 100 that displays a screen, a cabinet 200 coupled to a rear side of the display module 100 to support the display module 100, and a circuit case 300 coupled to the cabinet 200 and accommodating electrical components and/or printed circuit boards therein.

In the display device 1 according to an embodiment, six display modules 100 may be coupled to one cabinet 200. Specifically, two display modules 100 may be coupled to one cabinet 200 in the left-to-right direction X, and three display modules 100 may be coupled in the up-and-down direction Y. In other words, the display modules 100 may be combined in the cabinet 200 in a 2 * 3 matrix. However, the number of display modules 100 coupled to the cabinet 200 is not limited thereto. Two or more display modules 100 may be coupled to one cabinet 200.

Referring to FIG. 1, the display device 1 according to an embodiment may include eight displays 2. For example, the display device 1 may include eight cabinets 200, and 48 display modules 100 coupled to the eight cabinets 200. As such, the display device 1 may realize a large-sized screen by arranging a plurality of cabinets 200, to which a plurality of display modules 100 are coupled, adjacent to each other in the left-to-right direction X and the up-and-down direction Y. The number of cabinets 200 arranged adjacent to each other in the left-to-right direction X and the up-and-down direction Y is not limited thereto, and as described above, the number of display modules 100 coupled to the cabinet 200 is also not limited.

Referring to FIG. 2, the display modules 100 may be detachably coupled to the cabinet 200. The display modules 100 may be separated from the cabinet 200 toward a front of the cabinet 200. For example, the display device 1 may further include a separation device 400, and the separation device 400 may enable the display module 100 to be detachable toward the front of the cabinet 200. By using the separation device 400, a user wishing to separate the display module 100 from the cabinet 200 may not need to separate the display module 100 with bare hands, and may be able to separate the display module 100 from the cabinet 200 without supporting other parts, thereby improving user safety.

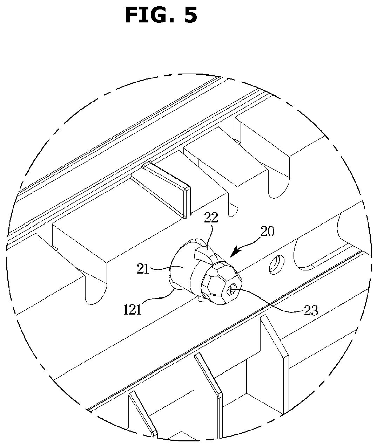

The display module 100 may be coupled to the cabinet 200 by magnetic force. The cabinet 200 and the circuit case 300 may include a plurality of magnets 10 arranged on the front surfaces thereof. The plurality of magnets 10 may include a plurality of first magnets 10 arranged on the front surface of the cabinet 200. The plurality of magnets 10 may include a plurality of second magnets 10 arranged on the front surface of the circuit case 300. The display module 100 may include a reinforcing member 140 (see FIG. 5) arranged on a rear side thereof and coupled by magnetic attraction to the plurality of first magnets 10 and the plurality of second magnets 10. The plurality of first magnets 10 arranged on the cabinet 200 and the plurality of second magnets 10 arranged on the circuit case 300 may be of the same configuration as each other. The plurality of first magnets 10 and the plurality of second magnets 10 may be collectively referred to as the plurality of magnets 10.

When a force greater than or equal to the magnetic attraction is applied via the separation device 400 such that the display module 100 is separated from the cabinet 200, the display module 100 may be separated from the cabinet 200.

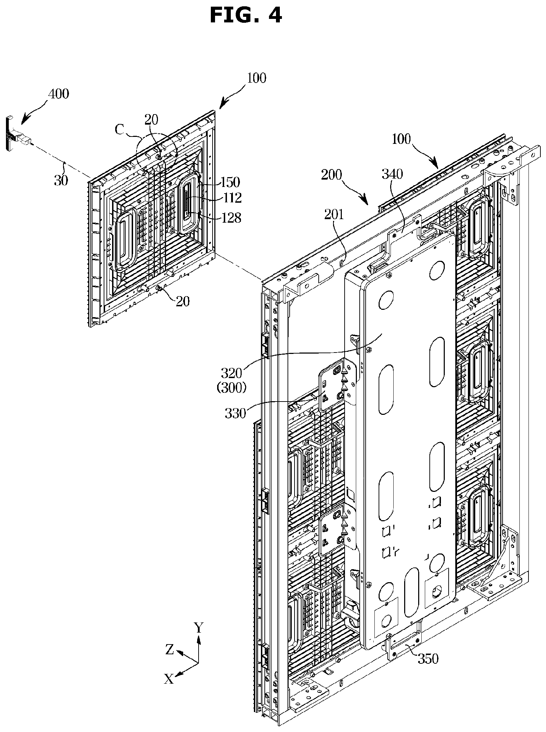

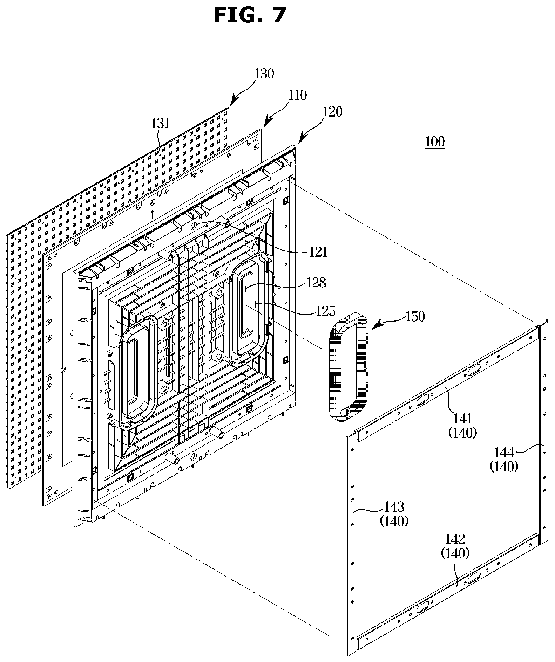

The cabinet 200 may include frames 210, 220, 230 and 240 (see FIG. 7) forming an outer edge of the cabinet 200. The circuit case 300 may be disposed inside the frames 210, 220, 230 and 240. The circuit case 300 may include a second connector 301 corresponding to a first connector 112 (see FIG. 4) included in each of the plurality of display modules 100. The circuit case 300 may include a first case 310 having a hexahedral shape with an open one side, and a second case 320 configured to cover the open one side of the first case 310.

The plurality of display modules 100 may be electrically connected to each other by coupling the first connector 112 of each of the plurality of display modules 100 to the second connectors 301 of the circuit case 300. In addition, the plurality of display modules 100 may receive power from a power supply device disposed inside the circuit case 300.

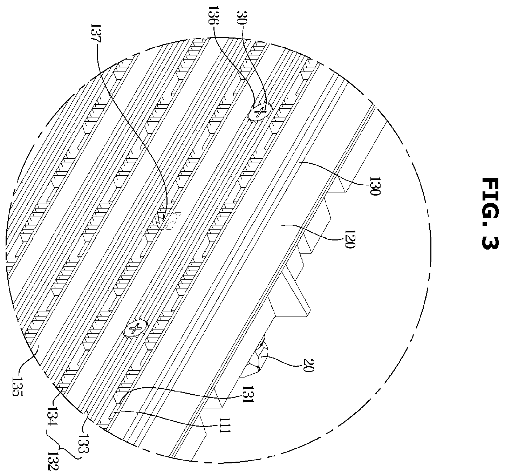

FIG. 3 is a partially enlarged view of the display device of FIG. 2. FIG. 3 is an enlarged view of region A in FIG. 2.

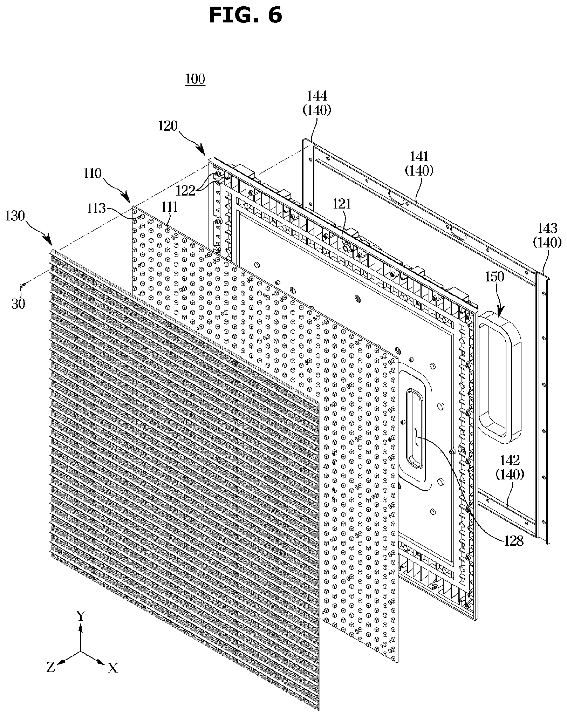

Referring to FIG. 3, the display module 100 may include a substrate 110 (see FIGS. 5 and 6), and a holder 120 configured to cover a side and rear of the substrate 110 and support the substrate 110. The substrate 110 may be attached to a front surface of the holder 120 via an adhesive, double-sided adhesive tape, or the like, or may be coupled to the holder 120 via a fastener, such as a screw.

A plurality of light-emitting diodes (LEDs) 111 may be mounted on the front surface of the substrate 110. The substrate 110 may be formed of a material, such as glass, polyimide (PI), frame retardant 4 (FR4), or the like.

Each of the plurality of LEDs 111 may include a red LED, a green LED, and a blue LED packaged into a single pixel. The plurality of LEDs 111 may be mounted on the substrate 110 in a matrix form. The plurality of LEDs 111 may be arranged to be spaced at regular intervals, and the spacing between the plurality of LEDs 111 may be varied depending on the resolution and size of the display device 1.

The display module 100 may include a cover plate 130 configured to cover a front side of the substrate 110. The cover plate 130 may include a plurality of LED holes 131 corresponding to each of the plurality of LEDs 111 mounted on the substrate 110. The plurality of LED holes 131 may allow the plurality of LEDs 111 to be exposed on a front surface of the cover plate 130.

The substrate 110 may be received within the cover plate 130 and the holder 120. The cover plate 130 and the holder 120 may be coupled together to form an internal space that accommodates the substrate 110.

The cover plate 130 may include a louver portion 132. The louver portion 132 may include a horizontal louver portion 133 and a vertical louver portion 134. The louver portion 132 may reduce or block moisture from entering the plurality of LEDs 111. In addition, the cover plate 130 may include a roof portion 135 arranged on an upper side of the plurality of LEDs 111. The roof portion 135 may protrude forwardly of the cover plate 130 to prevent water from directly entering the plurality of LEDs 111 from above.

The cover plate 130 may include a fastening hole 136 into which a fastening member 30 for coupling the cover plate 130, the substrate 110, and the holder 120 is inserted, and a fixing hole 137 into which a fixing member 20 is arranged to be inserted.

FIG. 4 is a rear exploded perspective view of the display in the display device according to an embodiment. FIG. 4 illustrates the cabinet and the display module separated from the cabinet, viewed from the rear, in the display device according to an embodiment. FIG. 5 is an enlarged view of the display of FIG. 4. FIG. 5 is an enlarged view of region C of FIG. 4.

Referring to FIGS. 4 and 5, the display module 100 may be separated toward the front side of the cabinet 200. For example, the display device 1 may further include the separation device 400, wherein the separation device 400 may allow the display module 100 to be detachable to the front side of the cabinet 200. When a force greater than or equal to the magnetic attraction between the cabinet 200 and the display module 100 is applied to the display module 100 in a direction opposite to the magnetic attraction via the separation device 400, the display module 100 may be separated from the cabinet 200.

According to an embodiment, the fixing member 20 may be provided in the form of a wing nut. The fixing member 20 may be inserted into a holder hole 121 of the holder 120. For example, the fixing member 20 may include a body portion having a cylindrical shape and inserted into the holder hole 121 of the holder 120, and a protruding portion 22 protruding outwardly from the body portion 21. The protruding portion 22 may be provided as a pair.

The fixing member 20 may prevent the display module 100 from being separated from the cabinet 200.

The cabinet 200 may include a through-hole 201 configured to allow the fixing member 20 to pass therethrough. The fixing member 20 may be rotatably arranged between an uncoupled position in which the fixing member 20 may pass through the through-hole 201 and a coupled position in which the fixing member 20 may not pass through the through-hole 201.

In the event of a damage or failure of the display module, a user may need to remove the display module from the cabinet. In this case, the user may couple the display module 100 to the cabinet 200 or uncouple the display module 100 from the cabinet 200 by manually rotating the fixing member 20, which passes through the through-hole 201 and protrudes to the rear of the cabinet 200, from the rear of the cabinet 200 by hand, without a separate tool.

When the fixing member 20 that has passed through the through-hole 201 is in the uncoupled position, the display module 100 may be detached from the cabinet 200 by applying a force greater than or equal to the magnetic force to the display module 100. In this case, by using the separation device 400, the user wishing to detach the display module 100 from the cabinet 200 may easily and conveniently detach the display module 100 from the cabinet 200 by pulling the display module 100 forward.

When the display module does not need to be detachable, the fixing member 20 may be positioned in the uncoupled position in which the fixing member 20 may not pass through the through-hole 201, thereby preventing the display module 100 from being detached from the cabinet 200.

The display module 100 may include the fixing hole 137 (see FIG. 3) that allows at least a portion of the fixing member 20 to be exposed on the front surface of the display module 100. The fixing hole 137 may be formed through the display module 100. One end of the fixing member 20 may be exposed to the front side of the display module 100 through the fixing hole 137. One end of the fixing member 20 may be provided with a groove of a given shape. For example, the other end of the fixing member 20 may be provided with a hexagonal groove 23 that is identical to the hexagonal groove 23 arranged on the one end of the fixing member 20.

The user may rotate the fixing member 20 from the front side of the display module 100 by using a tool having a shape corresponding to the groove formed on one end of the fixing member 20. As described above, by rotating the fixing member 20, the display module 100 may be brought into a state in which the display module 100 is detachable from the cabinet 200. This may allow the display module 100 to be detached from the cabinet 200 via the separation device 400 from the front of the display module 100 without accessing the rear of the cabinet 200.

In the display device according to an embodiment, the display module 100 may be coupled to the cabinet 200 via magnetic force, thereby reducing production costs by requiring a smaller amount of fixing members 20 rather than a larger amount. Furthermore, when changing the fixing member 20 to the uncoupled position from the rear of the cabinet 200, only a small number of fixing members 20 may need to be repositioned, and then the display module 100 may be easily detached from the cabinet 200 from the front using the separation device 400, thereby reducing labor.

FIGS. 6 and 7 are exploded perspective views of the display module in the display device according to an embodiment.

Referring to FIGS. 6 and 7, the display module 100 may be removable to the front of the cabinet 200. For example, the display device 1 may further include the separation device 400, and the separation device 400 may allow the display module 100 to be removable to the front of the cabinet 200. When a force greater than or equal to the magnetic attraction between the cabinet 200 and the display module 100 is applied to the display module 100 in a direction opposite to the magnetic attraction via the separation device 400, the display module 100 may be separated from the cabinet 200.

As described above, the display module 100 may be coupled to the cabinet 200 by magnetic force. The plurality of magnets 10 (see FIG. 2) may be arranged on the front surface of the cabinet 200, and the reinforcing member 140, which is attracted by the magnetic attraction of the plurality of magnets 10, may be arranged on the rear side of the display module 100.

The reinforcing member 140 may be coupled to the rear side of the holder 120. The reinforcing member 140 may be disposed on an edge of the rear surface of the holder 120. The reinforcing member 140 may include a first reinforcing member 141, a second reinforcing member 142, a third reinforcing member 143, and a fourth reinforcing member 144. The first reinforcing member 141 may be disposed adjacent to an upper edge of the rear surface of the holder 120 and may extend in a horizontal direction. The second reinforcing member 142 may be disposed adjacent to a lower edge of the rear surface of the holder 120 and may extend in the horizontal direction. The third reinforcing member 143 may be disposed adjacent to a left edge of the rear surface of the holder 120 and may extend in a vertical direction. The fourth reinforcing member 144 may be disposed adjacent to a right edge of the rear surface of the holder 120 and may extend in the vertical direction.

The reinforcing member 140 may add strength to the display module 100 by being coupled to the rear surface of the holder 120. The reinforcing member 140 may prevent the display module 100 from bending. The reinforcing member 140 may prevent physical deformation of the display module 100.

The reinforcing member 140 may be formed of a material that is attracted by the magnetic force of the magnet 10. The reinforcing member 140 may be formed of a material that is magnetizable by an external magnetic force. The reinforcing member 140 may be attracted to the magnet 10 and to each other by the polarity acquired by the reinforcing member 140 from the external magnetic force. The reinforcing member 140 may be configured to include a magnetic material that interacts with the magnet 10. For example, the reinforcing member 140 may include iron Fe.

The display module 100 may include the fixing member 20. The fixing member 20 may be disposed on each of an upper rear side and a lower rear side of the display module 100. However, the location of the fixing member 20 is not limited to the examples described above.

The display module 100 may include a first connector hole 128 that exposes the first connector 112 arranged on the rear side of the substrate 110 to the rear side of the display module 100. A sealing groove 125 for sealing the first connector hole 128 may be formed in the holder 120, and a sealing member 150 may be arranged in the sealing groove 125.

The sealing member 150 may be arranged to correspond to the shape of the sealing groove 125. The sealing member 150 may be provided in an approximately ring shape. The sealing member 150 may be made of a material capable of volume change, and may be configured to include, for example, rubber.

According to an embodiment, the sealing member 150 may be attached to the rear surface of the display module 100, but is not limited thereto. The sealing member 150 may also be attached to the front surface of the circuit case 300 corresponding to the sealing groove 125.

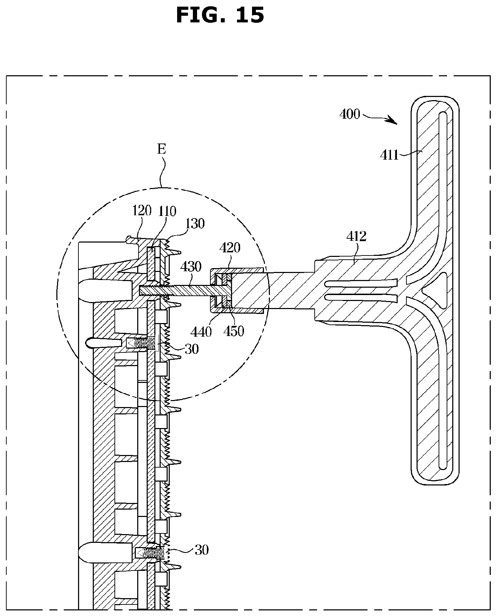

The holder 120 may include a support portion 122 configured to support the substrate 110. For example, the support portion 122 may support the substrate 110 from the rear side of the substrate 110. In addition, a receiving portion 124 may be formed in the support portion 122. The receiving portion 124 may receive the fastening member 30 to allow the holder 120 to be coupled to the substrate 110 and the like (see FIG. 15).

The substrate 110, the cover plate 130, and the holder 120 may be coupled to each other via the fastening member 30. The substrate 110 and the holder 120 may be formed with fastening holes 113, 136 into which the fastening member 30 is inserted, and the cover plate 130 may be provided with the fastening hole 136 into which the fastening member 30 is inserted. The fastening member 30 may be detachable forwardly. Once the fastening member 30 is detached, the substrate 110, the cover plate 130, and the holder 120 constituting the display module 100 may each be detached.

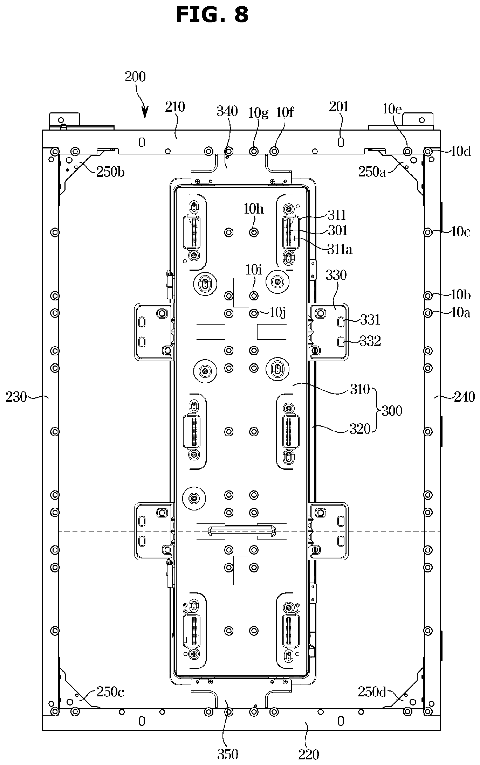

FIG. 8 is a front view of the cabinet in the display device according to an embodiment.

Referring to FIG. 8, the cabinet 200 may be formed by joining four frames 210, 220, 230 and 240 extending in one direction. The four frames 210, 220, 230 and 240 may be coupled together by four corner brackets 250a, 250b, 250c and 250d.

The frames 210, 220, 230 and 240 may include a first frame 210 forming an upper edge of the cabinet 200, a second frame 220 forming a lower edge of the cabinet 200, a third frame 230 forming a left edge of the cabinet 200, and a fourth frame 240 forming a right edge of the cabinet 200. The first frame 210 and the second frame 220 may be arranged in the horizontal direction, and the third frame 230 and the fourth frame 240 may be arranged in the vertical direction.

The first frame 210 and the fourth frame 240 may be coupled by the first corner bracket 250a. The first frame 210 and the third frame 230 may be coupled by the second corner bracket 250b. The second frame 220 and the third frame 230 may be coupled by the third corner bracket 250c, and the second frame 220 and the fourth frame 240 may be coupled by the fourth corner bracket 250d.

The first frame to the fourth frame 210, 220, 230 and 240 may be coupled to each other by the first corner bracket to the fourth corner bracket 250a, 250b, 250c and 250d to have a rectangular frame shape.

The circuit case 300 may be positioned in an inner center of the frames 210, 220, 230 and 240. The circuit case 300 may be coupled to the frames 210 and 220 by a first connection bracket 340 and a second connection bracket 350 arranged on an upper and lower sides of the circuit case 300, respectively.

The circuit case 300 may include the first case 310 forming the front and sides of the circuit case 300 with an open rear, and the second case 320 arranged to cover the open rear of the first case 310. The first case 310 and the second case 320 may be coupled to each other to form the circuit case 300. The first case 310 and the second case 320 may be coupled to each other such that their interiors are sealed. The first case 310 and the second case 320 may be coupled to each other such that water ingress from the outside is blocked.

A second connector hole 311a may be provided on the front side of the first case 310. The first case 310 may include a rib 311 arranged along the perimeter of the second connector hole 311a and protruding forward. The second connector 301 may be disposed inside the second connector hole 311a.

The second connector hole 311a, the second connector 301, and the rib 311 may be provided corresponding to the number of display modules 100 coupled to the cabinet 200.

The circuit case 300 may be provided with a power supply device (not shown) configured to supply power to the display module 100, a control board (not shown) configured to control the display module 100, and the like therein. In the present disclosure, electrical components may include the power supply device, the control board described above, and various electronic components.

The circuit case 300 may include a support bracket 330 configured to support the display module 100. The support brackets 330 may be coupled to opposite sides of the circuit case 300. Furthermore, the support brackets 330 may be arranged on each of the upper and lower sides at opposite sides of the circuit case 300. According to an embodiment, four support brackets 330 may be coupled to the circuit case 300.

The cabinet 200 may include the plurality of magnets 10. In addition, the circuit case 300 may include the plurality of magnets 10.

For example, the cabinet 200 may include the plurality of magnets 10 spaced apart from each other on the front surfaces of the first frame to the fourth frame 210, 220, 230 and 240.

In addition, the circuit case 300 may include the plurality of magnets 10 spaced apart from each other on the front side of the circuit case 300.

The cabinet 200 and the circuit case 300 according to an embodiment may include 10 magnets 10 per display module 100, that is, the cabinet 200 and the circuit case 300 may include a total of 60 magnets 10. The cabinet 200 may include 38 magnets 10, and the circuit case 300 may include 22 magnets 10. However, the number and location of the magnets 10 are not limited, and the number and location of the magnets 10 may be varied.

For example, to support the display module 100 coupled to the upper right of the cabinet 200, the cabinet 200 may include first to seventh magnets 10a, 10b, 10c, 10d, 10e, 10f and 10g, and the circuit case 300 may include eighth to tenth magnets 10h, 10i and 10j.

The plurality of magnets 10, as described above, may couple the display module 100 to the cabinet 200 by magnetically attracting the reinforcing member 140, which is made of a magnetizable material and disposed on the rear surface of the display module 100.

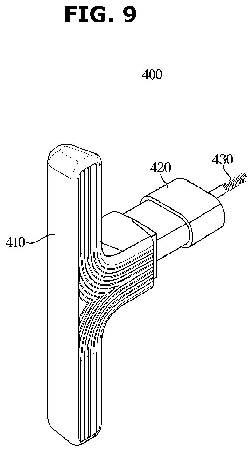

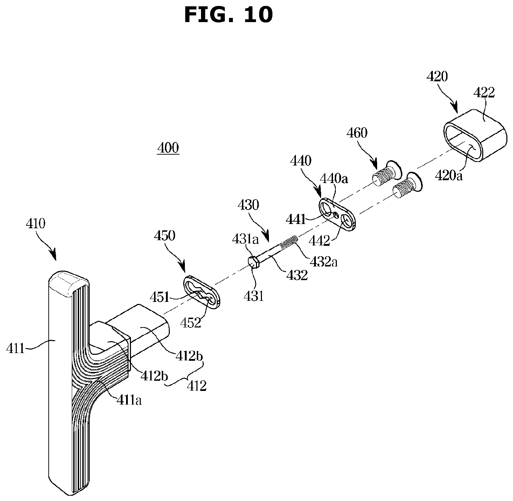

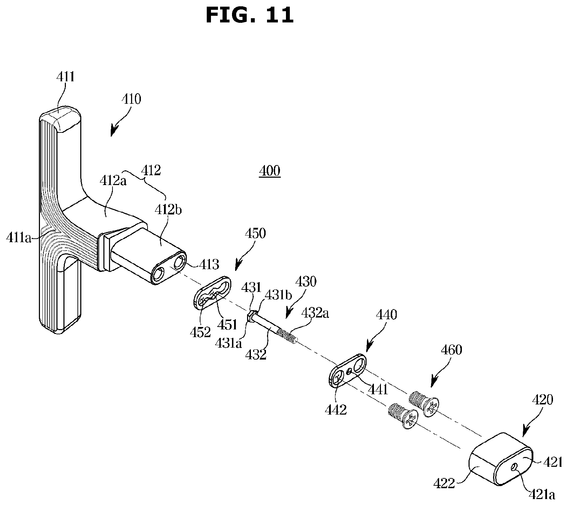

FIG. 9 is a perspective view of the separation device in the display device according to an embodiment. FIGS. 10 and 11 are exploded perspective views of the separation device shown in FIG. 9.

Referring to FIGS. 9 to 11, the display device according to an embodiment may include the separation device 400. The separation device 400 may be detachably mounted to the display module 100.

The separation device 400 may include a body 410.

The body 410 may have a grip portion 411 and an extension portion 412. The body 410 may be referred to as a grip member 410. The body 410 may include the grip portion 411. The grip portion 411 may be gripped by the user when the separation device 400 is inserted into and/or coupled to the display module 100. The grip portion 411 may be referred to as a handle portion 411. The grip portion 411 may extend in one direction. For example, the grip portion 411 may extend in a direction parallel to the display module 100 when the separation device 400 is inserted into and/or coupled to the display module 100.

In addition, the grip portion 411 may be referred to as a first extension portion 411, and the extension portion 412 may be referred to as a second extension portion 412. The first extension portion 411 and the second extension portion 412 may extend perpendicularly to each other.

A non-slip portion 411a may be formed on the body 410. The non-slip portion 411a may be arranged on one side of the grip portion 411. The non-slip portion 411a may be formed with a plurality of grooves and protrusions formed thereon to prevent t a hand or the like from slipping from the grip portion 411 when the user uses the separation device 400.

The body 410 may include the extension portion 412 extending from the grip portion 411. When the separation device 400 is used to detach the display module 100 from the cabinet 200, the extension portion 412 may extend from the grip portion 411 toward the display module 100. For example, the extension portion 412 may extend in a direction perpendicular to the direction in which the grip portion 411 extends.

The extension portion 412 may include a first portion 412a and a second portion 412b. The first portion 412a may be connected to the grip portion 411. The second portion 412b may extend from the first portion 412a. One end of the first portion 412a may be connected to the grip portion 411, and the other end may be connected to the second portion 412b. The first portion 412a may have a larger cross-sectional area than the second portion 412b.

The second portion 412b may be formed with an insertion hole 413 into which a fastener is inserted. The insertion holes 413 may be formed corresponding to the number of fasteners 460. The insertion holes 413 may be formed along an extension direction of the extension portion 412. At least a portion of the second portion 412b may be received in a case 420. For example, the second portion 412b may receive a head 431 and plates, which will be described later, between the second portion 412b and the case 420.

The separation device 400 may further include the case 420.

The case 420 may accommodate an insertion member 430 and plates 440 and 450. For example, a receiving space 420a may be provided within the case 420. The receiving space 420a may accommodate a portion of the insertion member 430 and the plates 440 and 450. The case 420 may be coupled to the body 410. For example, the case 420 may fit into the second portion 412b of the extension portion 412.

The case 420 may include a first wall 421 facing the display module 100 based on the separation device 400 facing the display module 100 to separate the display module 100 from the cabinet 200, and a second wall 422 formed in a direction opposite to the direction facing the display module 100 from the first wall 421 to form the receiving space 420a. The second wall 422 may form the perimeter of the case 420. The first wall 421 may be formed with a through-hole 421a through which the insertion member 430 passes, and the second wall 422 may form the receiving space 420a.

The separation device 400 may include the insertion member 430. The insertion member 430 may be coupled to the body 410 and/or the case 420. The insertion member 430 may be inserted into the display module 100 when the separation device 400 attempts to detach the display module 100 from the cabinet 200. The insertion member 430 may extend toward the display module 100.

The insertion member 430 may include the head 431 and an insertion portion 432.

The head 431 may be secured to the second plate 450. The head 431 may have a polygonal shape. For example, the perimeter 431a of the head may have a polygonal shape. The head 431 may be provided at one end of the insertion member 430.

The insertion portion 432 may extend from the head 431. For example, the insertion portion 432 may extend from the head 431 toward the display module 100 when the separation device 400 attempts to detach the display module 100 from the cabinet 200. The insertion portion 432 may extend from the head 431 and have a smaller cross-sectional area than the head 431 to correspond to the fastening hole 136.

A thread 432a may be formed at one end of the insertion portion 432. When the separation device 400 attempts to detach the display module 100 from the cabinet 200, the thread 432a may be formed at the one end of the insertion portion 432 facing the display module 100. In response to the separation device 400 separating the display module 100 from the cabinet 200, the thread 432a may be inserted into the display module 100 such that the separation device 400 may be mounted to the display module 100. The thread 432a may be formed at one end of the insertion portion 432 along the extension direction, and the head 431 may be coupled to the other end. The thread 432a may engage the substrate fastening hole 113 and the receiving portion 124 of the holder 120.

The separation device 400 may further include the first plate 440. The first plate 440 may be coupled with the insertion member 430. The insertion member 430 may be inserted through the first plate 440. In addition, the fastener 460 may be passed through the first plate 440 to secure the first plate 440 to the body 410. The first plate 440 may prevent linear movement of the insertion member 430. The first plate 440 may be accommodated within the case 420.

The first plate 440 may include a through-hole 441. The insertion portion 432 of the insertion member 430 may be inserted through the through-hole 441. The through-hole 441 may be formed to correspond to the perimeter of the insertion portion 432. The through-hole may be referred to as an anti-movement portion.

The first plate 440 may prevent the insertion member 430 from moving in a linear direction when the insertion member 430 is coupled to the body 410. One surface 440a of the first plate 440 and one surface 431b of the head 431 may contact each other to prevent the insertion member 430 from moving in a linear direction. For example, the first plate 440 may contact a surface of the head 431 facing the display module 100 to prevent the insertion member 430 from moving in the linear direction.

The first plate 440 may further include a fixing hole 442. The fastener 460 may pass through the fixing hole 442. The first plate 440 may be coupled to the body 410 by the fastener 460 passing through the fixing hole 442. The fixing holes 442 may be provided in a corresponding number of the fasteners 460.

The separation device 400 may further include the second plate 450. The second plate 450 may be coupled to the insertion member 430. The second plate 450 may prevent rotation of the insertion member 430. In addition, the fastener 460 may pass through the second plate 450 to secure the second plate 450 to the body 410. The second plate 450 may be accommodated within the case 420.

The second plate 450 may include an anti-rotation portion 451. The head 431 of the insertion member 430 may be inserted into the anti-rotation portion 451. The anti-rotation portion 451 may be formed to correspond to the perimeter 431a of the head. In the drawings, the anti-rotation portion 451 is shown as a hole, but may be provided in various shapes, such as a groove shape.

The second plate 450 may prevent the insertion member 430 from rotating when the insertion member 430 is coupled to the body 410. For example, the anti-rotation portion 451 may contact the perimeter 431a of the head to prevent the insertion member 430 from rotating. The anti-rotation portion 451 may be fitted to the perimeter 431a of the head. The anti-rotation portion 451 and the periphery 431a of the head may each include a polygonal shape.

The second plate 450 may further include a fixing hole 452. The fastener 460 may pass through the fixing hole 452. The second plate 450 may be coupled to the body 410 by the fastener 460 passing through the fixing hole 452. The fixing holes 452 may be provided in a corresponding number of the fasteners 460.

The second plate 450 may be more adjacent to the body 410 than the first plate 440. However, such an arrangement of the first plate 440 and the second plate 450 is not limited to the examples described above. Furthermore, although the separation device 400 has been described as including the plurality of plates 440 and 450, the separation device 400 of the present disclosure may prevent linear movement and rotation of the insertion member 430 through a single plate.

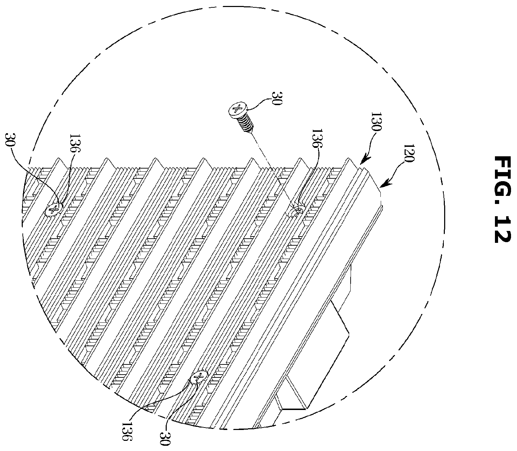

FIGS. 12 to 14 are views illustrating a process by which the separation device is mounted to the display module in the display device according to an embodiment. FIGS. 12 to 14 are enlarged views of region B in FIG. 2. While FIGS. 12 to 14 are described based on the upper right region of a display module, the separation device of the display device according to an embodiment may also be used in regions other than the above region.

Referring to FIGS. 12 to 14, the separation device 400 according to an embodiment of the disclosure may be detachably mounted to the display module 100. The separation device 400 may allow the display module 100 to be pulled forward and detached from the cabinet 200.

Referring to FIG. 12, the fastening members 30 for coupling the substrate 110, the holder 120, and the cover plate 130 may be detached from the fastening holes 136 arranged in the display module 100. In this case, the fastening members 30 may be, for example, the fastening members 30 disposed at a perimeter and/or corner portions of the display module 100.

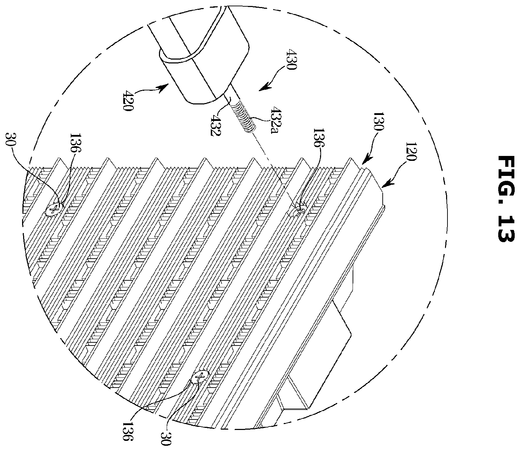

Referring to FIG. 13, the separation device 400 may be inserted into the display module 100 from which the fastening member 30 has been uncoupled. To detach the display module 100 from the cabinet 200, the fastening member 30 may be uncoupled from the fastening holes 136 and 113, and then the insertion member 430 may be inserted into a portion of the fastening holes 136 and 113. For example, the insertion portion 432 in which the thread 432a of the insertion member 430 is formed may be inserted into the cover plate 130.

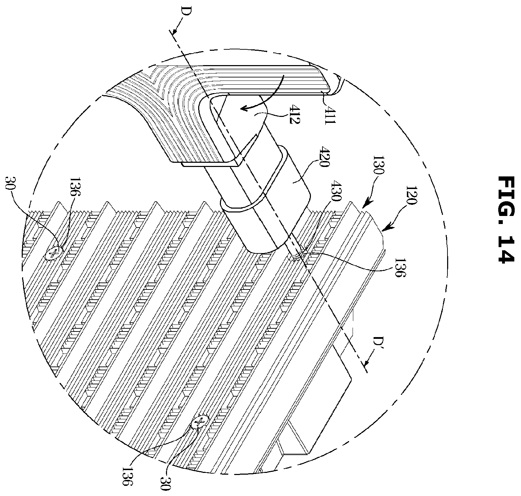

Referring to FIG. 14, the separation device 400 may be rotated in one direction to be inserted deeper into the fastening holes 136 and 113 of the display module 100. For example, the insertion member 430 of the separation device 400 may include the thread 432a, so that the separation device 400 may be rotated and inserted into the substrate 110 and the cover plate 130. The separation device 400 may be rotated so that the insertion member 430 is secured to the display module 100. For example, the separation device 400 may be rotated so that the insertion portion 432 is secured to the receiving portion 124a of the holder 120 and the substrate fastening hole 113. The direction in which the separation device 400 may be rotated is not limited to that shown in the drawings.

In this case, since the anti-rotation portion 451 arranged on the second plate 450 holds the head 431, the insertion member 430 may not rotate and the separation device 400 may rotate, allowing the separation device 400 to be inserted and secured within the display module 100. In other words, the insertion member 430 does not idle, allowing the separation device 400 to be secured within the display module 100.

By rotating the separation device 400 to insert it into the display module 100, the user may intuitively identify the extent to which the separation device 400 is coupled to the display module 100. Thus, workability for the user may be enhanced.

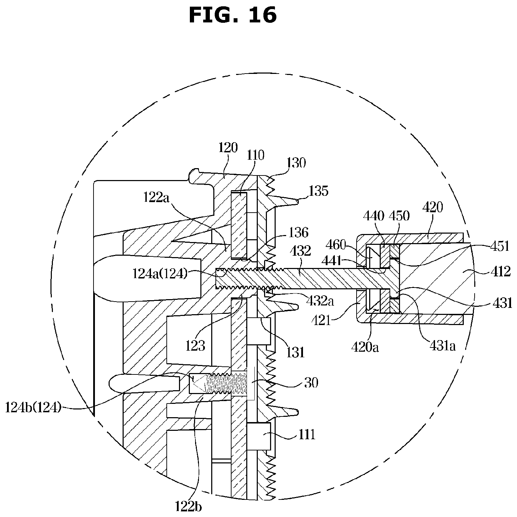

Furthermore, instead of newly creating a separate separation structure within the display module 100, it is only necessary to decouple the fastening member 30 used for coupling the substrate 110, the holder 120, and the cover plate 130, and then insert and couple the separation device 400 to the fastening holes 136 and 113 and the receiving portion 124a (see FIG. 16), thereby simplifying the structure of the display module 100 and reducing production costs.

FIG. 15 is a cross-sectional view of the display device shown in FIG. 14. FIG. 16 is an enlarged view of the display device shown in FIG. 15. FIG. 15 is a cross-sectional view of the display device of FIG. 14 cut along line D-D'. FIG. 16 is an enlarged view of region E of FIG. 15.

Referring to FIGS. 15 and 16, the holder 120 may include the support portion 122 and a coupling protrusion 123 protruding from the support portion 122.

The support portion 122 may include a first support portion 122a, and the coupling protrusion 123 may protrude from the first support portion 122a. A first receiving portion 124a may be formed within the first support portion 122a. The coupling protrusion 123 may be fastened with the fastening member 30 to allow the cover plate 130, the substrate 110, and the holder 120 to be coupled. The first receiving portion 124a may be provided within the coupling protrusion 123 so that the insertion member 430 or a coupling member may be inserted. The coupling protrusion 123 may pass through the substrate fastening hole 113 to support the cover plate 130. The diameter of the substrate fastening hole 113 may be larger than the diameter of the coupling protrusion 123.

A second receiving portion 124b may be formed within a second support portion 122b. The fastening member 30 for coupling the substrate 110 and the holder 120 may be disposed within the second support portion 122b.

Referring to FIG. 16, the insertion portion 432 of the separation device 400 may be disposed within the fastening hole 136 of the cover plate 130, the substrate fastening hole 113, and the first receiving portion 124a. The thread 432a may be inserted into the substrate fastening hole 113 and the first receiving portion 124a, so that the separation device 400 may be secured to the display module 100.

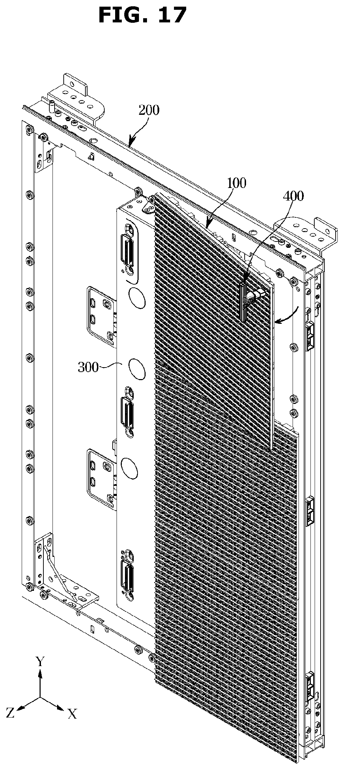

FIG. 17 is a view illustrating a state in which the display module is detached from the cabinet in the display device according to an embodiment.

Referring to FIG. 17, the user may separate the display module 100 from the cabinet 200 by pulling the separation device 400, which is coupled and fixed to the display module 100, toward the front side.

For example, when a force greater than or equal to the magnetic attraction is applied via the separation device 400 to cause the display module 100 to detach from the cabinet 200, the display module 100 may be separated from the cabinet 200.

Since one portion of one display module 100 that was coupled to the cabinet 200 has been detached from the cabinet 200, the other portion of the display module 100 may also be easily detached from the cabinet 200 by pulling the display module 100.

The user may easily detach the display module 100 from the cabinet 200 by inserting and coupling the separation device 400 into the fastening holes 136 and 113 and the receiving portion 124a, and then pulling the display module 100 forward. Thus, when the display module 100 needs to be repaired, visibility and workability may be improved by visually checking the assembly and disassembly status from the front.

Although certain example embodiments are illustrated and described above, the present disclosure is not limited to the certain embodiments, various applications may of course be performed by those skilled in the art without deviating from what is claimed in the scope of claims, and such applications should not be understood separately from the technical idea or prospects herein.

## Claims

1. A display device comprising:
a display module comprising a substrate on which light-emitting diodes (LEDs) facing forward are mounted and in which a fastening hole is formed for insertion of a fastening member;
a cabinet disposed on a rear side of the display module and comprising a magnet such that the display module and the cabinet are coupled via magnetic attraction; and
a separation device detachably mountable to the display module;
wherein the separation device comprises:
a grip portion extending in one direction,
an extension portion extending from the grip portion, and
an insertion member extending from the extension portion and having a cross-sectional area corresponding to the fastening hole so as to be insertable into the display module.

2. The display device of claim 1, wherein the display module is detachable from the cabinet by pulling the separation device forward.

3. The display device of claim 2, wherein, to detach the display module from the cabinet, the fastening member is detached from the fastening hole, and then the insertion member is inserted into the fastening hole.

4. The display device of claim 3, wherein the insertion member is secured to the display module by rotation of the separation device.

5. The display device of claim 4, wherein the display module is detached from the cabinet by securing the insertion member into the fastening hole and then pulling the grip portion forward.

6. The display device of claim 5, wherein the separation device further comprises:
a first plate through which the insertion member passes and configured to prevent the insertion member from moving in a linear direction, and
a second plate to which the insertion member is secured and configured to prevent the insertion member from rotating.

7. The display device of claim 6, wherein the insertion member comprises:
a head, and
an insertion portion extending from the head and having a smaller cross-sectional area than the head to correspond to the fastening hole.

8. The display device of claim 7, wherein the separation device further comprises a through-hole formed in the first plate corresponding to a perimeter of the insertion portion to allow the insertion portion to pass therethrough, and
the first plate contacts a surface of the head facing the display module.

9. The display device of claim 8, wherein the separation device further comprises an anti-rotation portion formed on the second plate corresponding to the head and configured to contact a perimeter of the head to prevent the insertion member from rotating.

10. The display device of claim 9, wherein the second plate is disposed more adjacent to the grip portion than the first plate.

11. The display device of claim 9, wherein the anti-rotation portion and the perimeter of the head comprise a polygonal shape.

12. The display device of claim 9, wherein a thread is formed on a portion of the insertion member insertable into the display module.

13. The display device of claim 9, wherein the separation device further comprises:
a body on which the grip portion and the extension portion are formed, and
a case coupled to the body and configured to accommodate the first plate, the second plate, and the insertion member.

14. The display device of claim 13, wherein the separation device further comprises:
a fastener accommodated in the case and configured to pass through the first plate and the second plate and be inserted into the body for coupling the first plate and the second plate, and
an insertion hole formed in the body for insertion of the fastener.

15. The display device of claim 4, wherein
the display module further comprises a reinforcing member disposed on a rear side of the holder, and
the reinforcing member couples the display module to the cabinet via magnetic attraction with the magnet of the cabinet.
